# EUROPÄISCHE PATENTSCHRIFT

(11) **EP 0 586 772 B1**
(45) Veröffentlichungstag und Bekanntmachung des Hinweises auf die Patenterteilung: **10.01.1996**
(21) Anmeldenummer: 92810690.5
(22) Anmeldetag: 09.09.1992
(51) Int. Cl.: H05K 3/00, G03F 7/16

(54) **Vorrichtung zur Beschichtung von plattenförmigem Gut, insbesondere von Leiterplatten**
Apparatus for coating plate-like articles, particularly printed circuit boards
Dispositif pour le revêtement d'articles en forme de plaques, notamment de plaques à circuit imprimé

(43) Veröffentlichungstag der Anmeldung: 16.03.1994
(73) Patentinhaber: CIBA-GEIGY AG, CH-4002 Basel (CH)
(72) Erfinder: Kuster,Kaspar, 4057 Basel (CH); Rüegge,Anton, 4123 Allschwil (CH)

(56) Entgegenhaltungen:
- EP-A- 0 145 648
- EP-A- 0 421 931
- EP-A- 0 441 743
- DE-A- 3 239 868
- US-A- 3 638 605

## Beschreibung

Die Erfindung betrifft eine Vorrichtung zur Beschichtung von plattenförmigem Gut, insbesondere von Leiterplatten gemäss Oberbegriff des Patentanspruchs 1.

Leiterplatten werden nachdem sie mit Leiterbahnen versehen sind mit einer Schutzschicht beschichtet. Bei dieser Schutzschicht handelt es sich um einen vorzugsweise UV-härtbaren belichtbaren Kunststoff, Lack oder dergleichen. Nach dem Trocknen der Schutzschicht wird diese in geeigneter Form belichtet und an den belichteten Stellen herausentwickelt. An diesen Stellen liegen dann die Leiterbahnen frei und können elektrisch kontaktiert werden. Bei beidseitig mit Leiterbahnen versehenen Leiterplatten wird auch die zweite Oberfläche der Platten beschichtet und analog zur ersten Oberfläche behandelt. Die Beschichtung der Leiterplatten erfolgt in einer Beschichtungsanlage, die eine Reihe von Bearbeitungsstationen umfasst, durch welche von den zu beschichtenden Leiterplatten der Reihe nach durchlaufen werden.

Die zuvor gereinigten Leiterplatten werden zum Eingang einer Beschichtungsstation transportiert, in der die Leiterplatten auf einer Seite mit der Schutzschicht versehen werden. Die Beschichtungsstation umfasst einen Giesstisch mit einem frei fallenden Giessvorhang, unter dem die Leiterplatten mit der zu beschichtenden Oberfläche nach oben hindurchtransportiert werden. Falls gewünscht bzw. erforderlich, ist vor der Beschichtungsstation eine Vorwärmstation angeordnet. Dort werden die zuvor gereinigten Leiterplatten vor der Beschichtung in einem Heissluftstrom vorgewärmt. Von der Vorwärmstation, die üblicherweise als Umlaufofen ausgebildet ist, werden die Leiterplatten an die Beschichtungsstation übergeben. Nach der Beschichtung der ersten Seite werden die Leiterplatten zu einer im Anschluss an die Beschichtungsstation angeordneten Ablüft- und Trockenstation transportiert. In dieser In der Ablüft- und Trockenstation wird Heissluft über die beschichtete Oberfläche der Leiterplatten geführt.

Auf diese Weise wird in der Beschichtung enthaltenes Lösungsmittel evaporiert (abgelüftet) und abgesaugt, und wird die beschichtete Oberfläche zmindest teilweise getrocknet. Bei den bekannten Beschichtungsanlagen werden die Leiterplatten in der Ablüft- und Trockenstation auch gewendet, sodass die beschichtete Oberfläche der Leiterplatte ausgangsseitig der Station nach unten weist. Soll auch die zweite Seite der Leiterplatten beschichtet werden, werden diese erneut unter einem Giessvorhang einer Beschichtungsstation hindurchtransportiert und schliesslich in einer Abluft- und Trockenstation abgelüftet und getrocknet.

Eine für die zweiseitige Beschichtung von Leiterplatten ausgebildete Beschichtungsanlage ist beispielsweise in der US-A-4.926,789 beschrieben. Bei dieser bekannten Beschichtungsanlage sind im Anschluss an die erste Beschichtungsstation und an die erste Ablüft- und Trockenstation eine zweite Beschichtungsstation und eine zweite Ablüft- und Trockenstation angeordnet. Die in der ersten Ablüft- und Trockenstation gewendeten Leiterplatten werden mit der noch unbeschichteten Oberfläche nach oben unter dem frei fallenden Giessvorhang der zweiten Beschichtungsstation hindurch transportiert. Danach werden sie in der zweiten Ablüft- und Trockenstation durch einen oder zwei hintereinander angeordnete umlaufende Ablüfttrockner transportiert. Dabei wird wiederum Heissluft über die beschichteten Oberflächen geführt, um in der Beschichtung enthaltenes Lösungsmittel zu evaporieren (abzulüften), wird das Lösungsmittel abgesaugt, und werden die Leiterplatten getrocknet.

In der US-A-5,113,785 und in der US-A-5,113,701 sind Beschichtungsanlagen beschrieben, welche es erlauben Leiterplatten wahlweise einseitig oder auch zweiseitig zu beschichten. Die beschriebenen Beschichtungsanlagen umfassen nur eine einzige Beschichtungsstation und eine einzige Ablüft- und Trockenstation. Sollen die Leiterplatten beidseitig beschichtet werden, dann werden sie nach dem Wenden erneut unter dem Giessvorhang der ersten Beschichtungsstation hindurch transportiert und anschliessend in der einzigen Ablüft- und Trockenstation abgelüftet und getrocknet. Bei der in der US-A-5,113,785 beschriebenen Anlage sind die Beschichtungsstation und die Ablüft- und Trockenstation in Längsrichtung der Anlage nebeneinander angeordnet. Vor und hinter der Beschichtungsstation bzw. der Ablüft- und Trockenstation sind Querförderer angeordnet, die die Leiterplatten aus der Transportzeile mit der Beschichtungsstation in die daneben angeordnete Transportzeile mit der Ablüft- und Trockenstation umsetzen. Die in der US-A-5,113,701 beschriebene Beschichtungsanlage ist einzeilig aufgebaut. Bei dieser Anlage ist die Ablüft- und Trockenstation im wesentlichen oberhalb der Beschichtungsstation angeordnet. Die einseitig oder beidseitig beschichteten Leiterplatten werden abgelüftet und getrocknet während sie in speziell ausgebildeten Haltevorrichtungen oberhalb der Beschichtungsstation wieder an den den Eingang der Beschichtungsstation oder zum Ausgang der Beschichtungsanlage transportiert werden. Abgesehen von dem Erfordernis von speziellen Halterungen für die Leiterplatten weist die Beschichtungsanlage eine grosse Bauhöhe auf, da die Ablüft- und Trockenstation im wesentlichen oberhalb der Beschichtungsstation angeordnet ist.

Während die beschriebenen Beschichtungsanlagen des Standes der Technik den Erfordernissen der modernen Leiterplattenbeschichtungstechnik Rechnung tragen, sind sie doch in der einen oder anderen Hinsicht verbesserungswürdig. Allen drei beschriebenen Beschichtungsanlagen ist gemeinsam, dass sie einen relativ grossen Aufwand bezüglich der Infrastruktur am Aufstellungsort erfordern. Der Installationsaufwand ist beträchtlich, müssen doch die Vorwärmstation und die Ablüft- und Trockenstation(en) jeweils an das Zuluft- und Abluftsystem am Standort eingebunden werden. Dabei ist insbesondere zu beachten, dass die Abluft der Ablüft- und Trockenstation(en) im allgemeinen entflammbare Lösungsmitteldämpfe enthält. Die Installationen müssen daher sicherheitstechnischen Standards genügen. Die lösungsmittelhältige Abluft muss den am Standort vorhandenen Entsorgungseinrichtungen zugeführt werden, wo die Lösungsmitteldämpfe zusammen mit anderer Abluft verbrannt oder auf andere Art aus der Abluft entfernt werden.

Zum Ansaugen der Zuluft und für die Umwälzung der Luft in jeder Ablüft- und Trockenstation und, falls vorhanden, in der Vorwärmstation müssen Pumpen vorgesehen werden. Die Zuluft der Vorwärmstation und insbesondere der Ablüft- und Trockenstation(en) muss erwärmt werden. Zu diesem Zweck sind für die einzelnen Stationen Heizeinrichtungen vorzusehen, die die Zuluft auf die gewünschte Temperatur erwärmen. Die Anordnung der Ansaug- und Umwälzpumpen und der Heizeinrichtung innerhalb der Vorwärmstation und insbesondere innerhalb jedes Ablufttrockners vergrössert den Platzbedarf dieser Einrichtungen beträchtlich, insbesondere ist ihre Bauhöhe oftmals zu gross und wirft Probleme beim Transport und bei der Montage dieser Einrichtungen auf.

Die bekannten Beschichtungsanlagen für Leiterplatten müssen an Standorten installiert werden, die gewisse Mindeststandards hinsichtlich der Reinraumqualität erfüllen. Auf diese Weise soll verhindert werden, dass Schmutz- oder Staubpartikel auf die zu beschichtenden Oberflächen der Leiterplatten gelangen und die Qualität der Beschichtung beeinträchtigen. Auf der Oberfläche abgelagerte Schmutz- oder Staubpartikel können bei der nachfolgenden Belichtung der Beschichtung als Streuzentren wirken, sodass die Beschichtung an unerwünschten Stellen belichtet und in Folge herausentwickelt wird. Im schlimmsten Fall können die Verunreinigungen auf den Oberflächen sogar zu Kurzschlüssen zwischen den Leiterbahnen führen. In jedem Fall ist die betroffene Leiterplatte unbrauchbar. Um die geforderte Reinraumqualität zu erzielen, muss ein grosser Aufwand hinsichtlich der Reinigung und Filterung des Luftvolumens in den Räumlichkeiten, in denen die Beschichtungsanlage installiert ist, betrieben werden. Berücksichtigt man den Platzbedarf von Beschichtungsanlagen, insbesondere von solchen für eine beidseitige Beschichtung von Leiterplatten, und die erforderliche Grösse der Räumlichkeiten, in denen die Beschichtungsanlagen demnach aufgestellt werden müssen, so ist leicht einsichtig, dass die Erstellung und Aufrechterhaltung der erforderlichen Reinraumqualität einen nicht unbeträchtlichen Anteil an den Betriebskosten der Beschichtungsanlage einnehmen.

Es ist daher die Aufgabe der vorliegenden Erfindung, den erwähnten verbesserungswürdigen Umständen der Beschichtungsanlagen des Standes der Technik Abhilfe zu schaffen. Insbesondere soll durch die Erfindung eine Vorrichtung zum Beschichten von plattenförmigem Gut, insbesondere von Leiterplatten geschaffen werden, bei der der erforderliche Installationsaufwand deutlich reduziert ist. Die Beschichtungsanlage soll weitgehend autonom von der am Aufstellungsort vorhandenen Infrastruktur betrieben werden können, nur die notwendigsten Anschlüsse sollen erforderlich sein. Dabei soll die Beschichtungsanlage kompakt aufgebaut sein und einen geringen Platzbedarf aufweisen. Die Bauhöhe soll gering sein, sodass der Transport der Anlage problemlos erfolgen kann und ihre Installation am Aufstellungsort keine besonders gestalteten Räumlichkeiten erfordert. Eine weitere Aufgabe der vorliegenden Erfindung besteht darin, eine Beschichtungsanlage zu schaffen, die eine Reduktion des bereitzustellenden Reinraumvolumens erlaubt.

All diese und noch weitere damit zusammenhängende Aufgaben werden durch eine Beschichtungsanlage für plattenförmiges Gut, insbesondere für Leiterplatten, gelöst, welche die im kennzeichnenden Teil des Patentanspruchs 1 angeführten Merkmale aufweist Besonders bevorzugte Ausführungsvarianten, die weitere Teilaufgaben der Erfindung lösen, sind Gegenstand der jeweils abhängigen Patentansprüche.

Im folgenden wird die Erfindung anhand der Zeichnungen in mehreren Ausführungsbeispielen erläutert. Dabei zeigen in teilweise schematischer Darstellung:
Fig. 1 eine erste erfindungsgemässe Beschichtungsanlage,
Fig. 2 ein zweites Ausführungsbeispiel der Beschichtungsanlage,
Fig. 3 ein Blockschema eines Ausführungsbeispieles eines Luftaufbereitungsmoduls und
Fig. 4 und Fig. 5 zwei weitere Ausführungsbeispiele der Beschichtungsanlage.

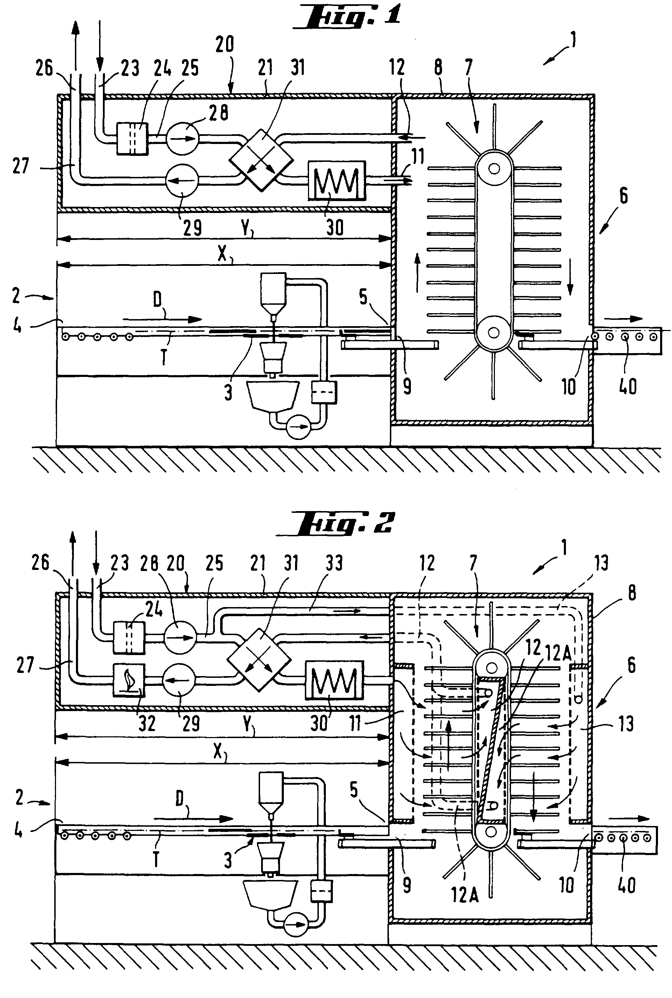

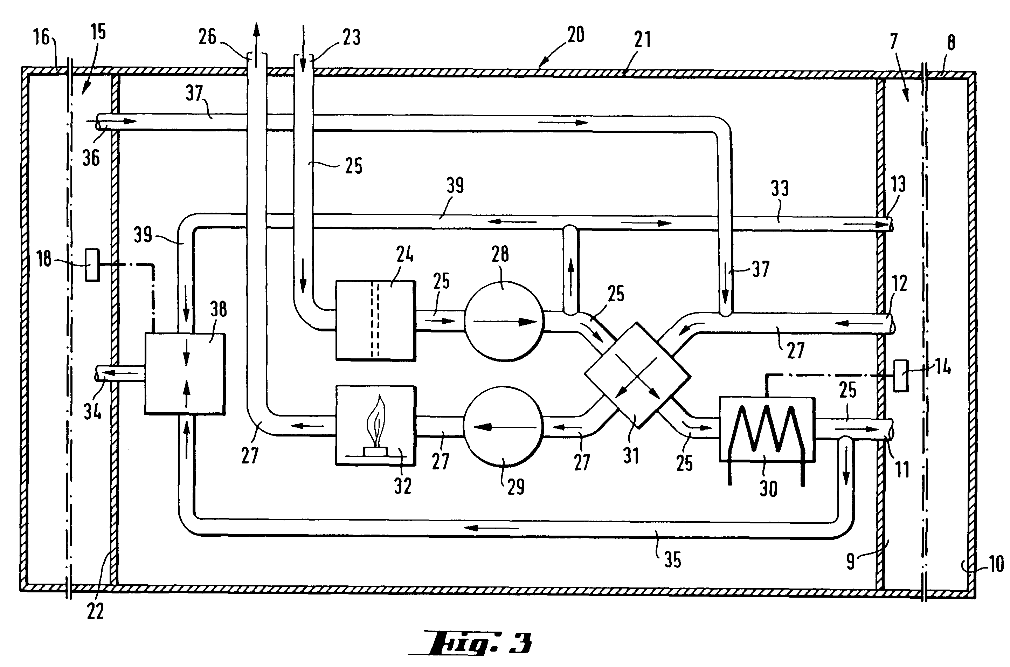

Die in Fig. 1 und 2 schematisch dargestellte Beschichtungsanlage ist gesamthaft mit dem Bezugszeichen 1 bezeichnet. Sie umfasst in der Reihenfolge ihrer Anordnung eine Beschichtungsstation 2 und eine Ablüft- und Trockenstation 6, die in Durchlaufrichtung D nacheinander von den Leiterplatten durchlaufen werden. Ausgangs der Ablüft- und Trockenstation 6 ist eine Ausgaberollenbahn 40 angeordnet, über die die Leiterplatten weiteren Bearbeitungsanlagen zugeführt werden können. Die Beschichtungsstation 2 umfasst einen Giesstisch 3 mit einem Giesskopf. Der Giesskopf ist dabei derart ausgebildet, dass vorzugsweise UV-härtbarer Kunststoff, Lack oder dergleichen, der zum Giesskopf gepumpt wird, einen frei fallenden Giessvorhang bildet, unter dem die zu beschichtenden Oberflächen der Leiterplatten hindurchtransportiert werden. Die seitliche Ausdehnung des Giessvorhangs, quer zur Transportrichtung D der Leiterplatten, wird dabei durch Giessmesser begrenzt. Ein derartiger Giesskopf ist beispielsweise in der US-A-4,559,896 beschrieben. Durch die Giessmesser ist sichergestellt, dass ein schmaler Rand entlang der Längsseiten der Leiterplatten frei von der Beschichtung bleibt.

In der Beschichtungsstation 2 werden die Leiterplatten vorzugsweise an ihren Längsrändern seitlich geführt. Vorzugsweise sind die Führungsmittel durch zwei seitlich angeordnete Transportbänder gebildet, welche jeweils in Transportrichtung D der Leiterplatten um einen zugehörigen Richtholm herumlaufen. Die Richtholme sind auf die Breite der Leiterplatten automatisch, vorzugsweise elektro-pneumatisch einstellbar. Auf diese weise werden die Leiterplatten ausgerichtet, sodass ihre Längskanten etwa parallel zur Transportrichtung D verlaufen. Die Transportbänder greifen die Längskanten der Leiterplatten und transportieren sie zur Beschichtung unter dem frei fallenden Giessvorhang hindurch. Dabei sorgt die seitlich den Giessvorhang begrenzenden Giessmesser dafür, dass die Transportbänder nicht verschmutzt werden. Eine derartige Beschichtungsstation mit allen ihren Einzelheiten ist beispielsweise in der europäischen Patentanmeldung Nr.91810879.6 beschrieben.

Ausgangs 5 der Beschichtungsanlage folgt in Transportrichtung D eine Ablüft- und Trockenstation 6. Diese umfasst einen Ablüfttrockner 7, der vorzugsweise als Heissluft-Umlauftrockner ausgebildet ist Dabei werden die von der Beschichtungsstation kommenden Leiterplatten in spezielle Halteelemente eingegeben, die im Inneren des Gehäuses des Ablüfttrockners an einer oder mehreren endlos umlaufenden Ketten, Seilen oder dergleichen befestigt sind. Der Ablüfttrockner weist eine im wesentlichen vertikal orientierte Bauweise auf. Die etwa horizontal abstehenden Halteelemente werden vertikal in die Höhe transportiert, am oberen Umlenkpunkt umgelegt, sodass die in den Halterungen befindlichen Platten gewendet werden, und etwa horizontal von den Ketten oder Seilen wegstehend wieder vertikal nach unten transportiert Nach der Übergabe der getrockneten Leiterplatten an die Ausgaberollenbahn 40, werden die Halterungen am unteren Umlenkpunkt der Ketten oder Seile umgelenkt und wieder vertikal nach oben transportiert Ein derartiger Durchlauftrockner ist beispielsweise in der Europäischen Patentanmeldung Nr. 91810881.2, (EP-A-0541879). Im Ablüfttrockner werden die beschichteten Leiterplatten einem Heissluftstrom ausgesetzt Dabei wird in der Beschichtung enthaltenes Lösungsmittel evaporiert (abgelüftet) und die Beschichtung mehr oder weniger getrocknet.

Erfindungsgemäss umfasst die Ablüft- und Trockenstation 6 ein Luftaufbereitungsmodul, welches in den Fig. 1 bis 5 jeweils gesamthaft mit dem Bezugszeichen 20 bezeichnet ist. Das Luftaufbereitungsmodul 20 ist in einem Gehäuse 21 angeordnet, das oberhalb der Transportebene T der Leiterplatten eingabeseitig 9 an das Gehäuse 8 des Ablüfttrockners 7 anschliesst und sich oberhalb des Giesstisches 3 der Beschichtungsstation 2 erstreckt. Auf diese Weise wird der freie Raum oberhalb der Beschichtungsstation 2 für die Unterbringung der für die Luftaufbereitung erforderlichen Aggregate genützt. Vorzugsweise ist das Gehäuse 21 des Luftaufbereitungsmoduls 20 fest mit dem Gehäuse 8 des Ablüfttrockners 7 verbunden, sodass keine weiteren Abstützorgane für das freie Ende des Gehäuses 21 erforderlich sind. Die Abmessungen des Gehäuses 21 des Luftaufbereitungsmoduls 20 sind dabei so gewählt, dass es nicht über die Höhe und über die Breite des Ablüfttrockners 7 hinausragt, und dass seine Länge Y der Länge X der Beschichtungsstation 2 entspricht. Auf diese Weise sind die Abmessungen und der Platzbedarf der Beschichtungsanlage nur durch die Abmessungen der Beschichtungsanlage 2 und der Ablüft- und Trockenstation 6 samt der Ausgaberollenbahn 40 festgelegt. Das Luftaufbereitungsmodul ist in dem freien Raum oberhalb des Giesstisches 3 angeordnet, der ansonsten ungenützt bleibt.

In den Fig. 1 bis 3 sind drei Ausführungsbeispiele des Luftaufbereitungsmoduls 20 schematisch dargestellt. Gemäss dem Ausführungsbeispiel in Fig. 1 weist das Luftaufbereitungsmodul 20 eine Zuluftöffnung 23 und einen Abluftanschluss 26 auf, die, wie dargestellt, beispielsweise in der deckenseitigen Längswand des Gehäuses 21 vorgesehen sind. Die Zuluftöffnung 23 steht mit einer im Inneren des Gehäuses 21 angeordneten Zuluftleitung 25 in Verbindung, die ihrerseits in einen eingangsseitig 9 des Ablüfttrockners 7 angeordneten Zuluftkanal 11 mündet. Vorzugsweise ist unmittelbar an der Zuluftöffnung 23 ein Luftfilter 24 angeordnet, welches Verunreinigungen aus der Zuluft herausfiltert. Eine in der Zuluftleitung 25 angeordnete erste Umwälzeinrichtung 28 fördert die Zuluft von der Zuluftöffnung 23 in den Ablüfttrockner. Der Abluftanschluss 26 ist mit einer Abluftleitung 27 verbunden, die in einen Abluftkanal 12 mündet, der im Inneren des Ablufttrockners 7 angeordnet ist. Die im Ablüfttrockner 7 anfallende Abluft, die im allgemeinen lösungsmittelhaltig ist, wird mit Hilfe einer zweiten Umwälzeinrichtung 29, die in der Abluftleitung 27 innerhalb des Gehäuses 21 des Luftaufbereitungsmoduls 20 angeordnet ist, vom Ablüfttrockner 7 zum Abluftanschluss 26 transportiert. Vorzugsweise sind die erste und die zweite Umwälzeinrichtung 28, 29 Ventilatoren, deren Förderleistung regelbar ist.

Zur Erwärmung der Zuluft auf die gewünschte Temperatur umfasst das Luftaufbereitungsmodul 20 eine Heizeinrichtung 30, die zwischen der ersten Umwälzeinrichtung 28 und der Mündung der Zuluftleitung 25 in den Zuluftkanal 11 im Zuluftstrom angeordnet ist. Vorzugsweise ist die Heizeinrichtung 30 eine elektrische Widerstandsheizung, die mit einer Thermostateinrichtung 14 verbunden ist, welche eingangsseitig 9 im Inneren des Ablüfttrockners 7 angeordnet ist (Fig. 3). Mit Hilfe der Thermostateinrichtung 14 ist die Heizleistung der elektrischen Widerstandsheizung 30 nach Massgabe der gewünschten Temperatur im Ablüfttrockner 7 vorzugsweise automatisch regelbar. Zur Ausnutzung der Wärmemenge, die in der vom Ablüfttrockner 7 kommenden erhitzten Abluft enthalten ist, wird die Abluft zu einem Wärmetauscher 31 transportiert. Der Wärmetauscher 31 ist zwischen der ersten Umwälzeinrichtung 28 und der Heizeinrichtung 30 angeordnet und dient zur Vorwärmung der Zuluft. Der Wärmetauscher 31 weist Anschlüsse für die Zuluftleitung 25 und für die Abluftleitung 27 auf. Dabei ist sichergestellt, dass die Zuluft und die Abluft entkoppelt sind, sich also nicht vermischen können.

Eine Beschichtungsanlage 1 mit einem derart ausgebildeten Luftaufbereitungsmodul 20 erfordert am Aufstellungsort nur mehr einen geringen Installationsaufwand. Die Zuluft kann aus der Umgebung entnommen werden. Für den Fall, dass die Zuluft aus seiner Versorgungsleitung entnommen werden soll, wird einfach ein Anschluss an diese Versorgungsleitung erstellt. An dem am Gehäuse 21 des Luftaufbereitungsmoduls 20 vorgesehenen Abluftanschluss 26 wird eine Verbindungsleitung zu einer zentralen Abluftentsorgungsanlage angeschlossen, über welche die im allgemeinen lösungsmittelhältige Abluft zu einer Verbrennungsanlage oder einer ähnlichen Entsorgungsanlage transportiert wird.

Das in Fig. 2 dargestellte Ausführungsbeispiel des Luftaufbereitungsmoduls 20 entspricht weitgehend dem Ausführungsbeispiel gemäss Fig. 1. Zusätzlich weist es zwischen der ersten Umwälzeinrichtung 28 und dem Wärmetauscher 31 eine Abzweigleitung 33 auf, über die kalte Zuluft zu einem ausgangsseitig 10 im Inneren des Ablüfttrockners 7 angeordneten Kaltluftkanal 13 transportiert wird. Auf diese Weise können die erhitzten Leiterplatten während des Abwärtstransportes und vor dem Ausfahren aus dem Ablüfttrockner 7 wieder abgekühlt werden. Nach dem Überstreichen der Leiterplattenoberfläche wird die Kaltluft über einen zweiten Abluftkanal 12A abgesaugt, der mit dem Abluftkanal 12 in verbunden ist. Abgesehen von der Versorgung des Ablüfttrockners mit kalter Zuluft ist das Luftaufbereitungsmodul gemäss Fig. 2 auch mit einer Abluftreinigungseinrichtung 32 ausgestattet. Die Abluftreinigungseinrichtung 32 ist zwischen der zweiten Umwälzeinrichtung 29 und dem Abluftanschluss 26 in der Abluftleitung 27 angeordnet. Vorzugsweise ist sie als katalytische Abluftverbrennungsanlage ausgebildet, wie sie dem Fachmann geläufig ist und beispielsweise in dem Prospekt Nr. 102-2(0285) der Firma LTG Lufttechnische GmbH, Wernerstrasse 119-129, 7000 Stuttgart 40 (Zuffenhausen) beschrieben ist

Eine Beschichtungsanlage 1, die, wie in Fig. 2 dargestellt, ein Luftaufbereitungsmodul 20 aufweist, das mit einer Abluftreinigungseinrichtung 32 ausgestattet ist, ist praktisch unabhängig von der Abluftentsorgung am Standort. Durch den Abluftanschluss 26 wird von den Lösungsmittelresten gereinigte Abluft ausgestossen, die unbedenklich ist und sogar an die Umgebung abgegeben werden kann. Der Installationsaufwand für Zuluftleitungen und für Abluftleitungen fällt auf diese Weise gänzlich weg.

Fig. 3 gibt ein Blockschema eines Luftaufbereitungsmoduls 20 wieder, welches für den Anschluss einer vor dem Eingang 4 der Beschichtungsstation 2 angeordneten Vorwärmstation 15 für die Leiterplatten vorbereitet ist Dazu ist das Luftausbereitungsmodul 20 mit je einem Zuluft- und Abluftversorgungsanschluss 34 bzw. 36 ausgestattet, welche Anschlüsse auf der dem Ablüfttrockner 7 abgewandten Stirnseite 22 des Gehäuses 21 des Luftaufbereitungsmoduls 20 angeordnet sind. Dabei mündet der Zuluftversorgungsanschluss 34 in eine Zuluftversorgungsleitung 35, die nach der Heizeinrichtung 30 für die Zuluft von der Zuluftleitung 25 abzweigt. Der Abluftversorgungsanschluss 36 ist mit einer Abluftversorgungsleitung 37 verbunden, die vor dem Wärmetauscher 31 in die Abluftleitung 27 mündet. Vorzugsweise ist in der Zuluftversorgungsleitung 34 ein Luftmischer 38 angeordnet, in den eine Kaltluftleitung 39 mündet, die zwischen der ersten Umwälzeinrichtung 28 und dem Wärmetauscher 31 von der Zuluftleitung 25 abzweigt. Der Luftmischer 38 ist vorzugsweise automatisch betreibbar und regelbar und ist mit einer Thermostateinrichtung 18 verbunden, die innerhalb des Gehäuses 16 der Vorwärmstation 15 angeordnet ist, und mit Hilfe welcher das Verhältmis von erhitzter und von kalter Zuluft im Luftmischer 38 nach Massgabe der gewünschten Temperatur in der Vorwärmstation 15 regelbar ist Falls erforderlich, kann in der Zuluftversorgungsleitung 25 eine weitere Umwälzeinrichtung angeordnet sein, welche vorzugsweise ein Ventilator ist, dessen Förderleistung nach Wunsch regelbar ist.

Bei einer Beschichtungsstation 1, die ein Luftaufbereitungsmodul 20 gemäss dem in Fig. 3 dargestellten Ausführungsbeispiel umfasst, kann auch eine Vorwärmstation 15 angeschlossen werden, ohne von der Infrastruktur am Aufstellungsort der Anlage abhängig zu sein. Das Luftaufbereitungsmodul 20 entnimmt die Zuluft vorzugsweise der Umgebung und stellt die erforderliche kalte oder auf die gewünschte Temperatur erhitzte Zuluft für den Ablüfttrockner 7 und für die Vorwärmstation 15 in der erforderlichen Menge bereit. Die vom Ablüfttrockner 7 und von der Vorwärmstation 15 kommende Abluft wird durch den Wärmetauscher 31 geführt, wo sie einen Grossteil der in ihr enthaltenen Wärme an die noch kalte Zuluft abgibt und diese vorwärmt. Danach wird die Abluft zur Abluftreinigungseinrichtung 32 gefördert, wo das in der Abluft enthaltene Lösungsmittel beispielsweise katalytisch verbrannt oder auf andere Art entfernt wird. Die gereinigte Abluft kann über den Abluftanschluss 26 an die Umgebung abgegeben werden.

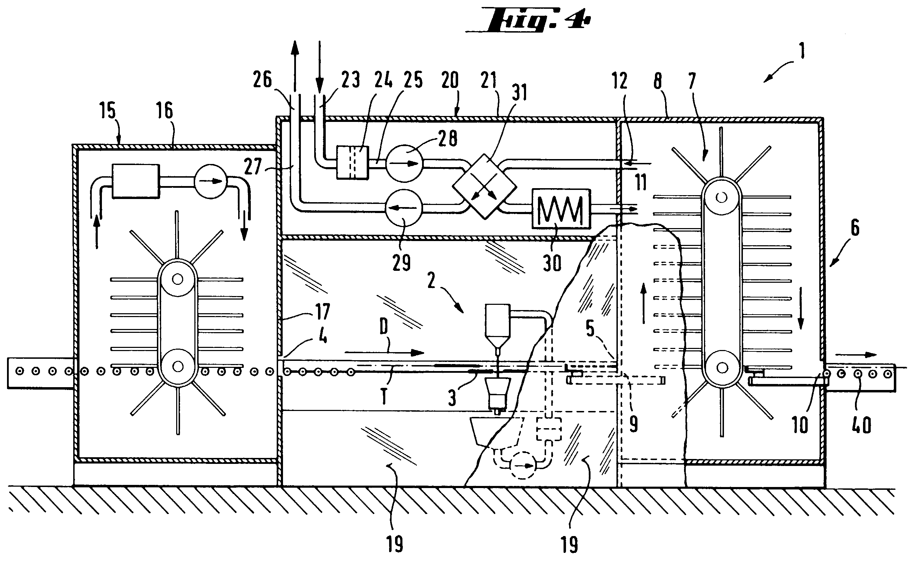

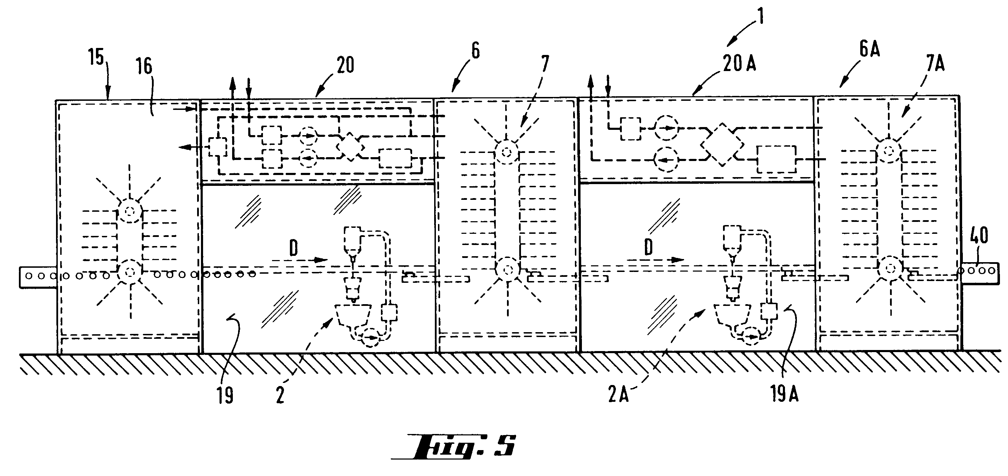

Bei den in den Fig. 4 und 5 dargestellten Ausführungsbeispielen der erfindungsgemässen Beschichtungsanlage 1 wird darüber hinaus auch noch der Aufgabe Rechnung getragen, das erforderliche Reinraumvolumen für die Anlage zu reduzieren. Zu diesem Zweck ist die Beschichtungsstation 2 der in Fig. 4 dargestellen Beschichtungsanlage 1 erfindungsgemäss durch bauliche Massnahmen im wesentlichen von der Umgebungsluft abgeschottet. Die Abschottung der Beschichtungsstation 2 ist durch zwei Wände 19, vorzugsweise Plexiglaswände, gebildet, die von der Unterkante des Gehäuses 21 des Luftaufbereitungsmoduls 20 bis zum Boden reichen und sich zu beiden Längsseiten der Beschichtungsstation 2 von der eingangsseitigen 9 Gehäusewand des Ablüfttrockners 7 über die gesamte Länge der Beschichtungsstation 2 erstrecken. Am Eingang 4 der Beschichtungsstation 2 schliessen die beiden Wände an eine Stirnschottwand 17 an. Im Falle einer Beschichtungsanlage 1, welche vor der Beschichtungsstation 2 eine Vorwärmstation 15 für die Leiterplatten umfasst, wird die Stirnschottwand 17, wie dargestellt, von der ausgangseitigen Gehäusewand der Vorwärmstation 15 gebildet Im Falle einer Beschichtungsstation 1 ohne Vorwärmstation 15, ist eine separate Schottwand vorgesehen, die eingangs 4 der Beschichtungsstation 2 von der Unterkante des Gehäuses 21 des Luftaufbereitungsmoduls 20 bis zum Boden reicht und in der Höhe der Transportebene T der Leiterplatten nur einen Eingabeschlitz für die zu beschichtenden Leiterplatten aufweist Die in Fig. 5 dargestellte Beschichtungsanlage 1 weist im Anschluss an die erste abgeschottete Beschichtungsstation 2 und die erste Ablüft- und Trockenstation 6 mit Luftaufbereitungsmodul 20 eine zweite Beschichtungsstation 2A auf, die ebenfalls gegenüber der Umgebungsluft im wesentlichen abgeschottet ist. Im Anschluss an die zweite Beschichtungsstation 2A ist eine zweite Ablüft- und Trockenstation 6A angeordnet, die analog zur ersten Station einen Ablüfttrockner 7A und ein damit verbundenes Luftaufbereitungsmodul 20A aufweist. Eine derartige Beschichtungsanlage 1 ist insbesondere für die beidseitige Beschichtung von plattenförmigem Gut, insbesondere von Leiterplatten konzipiert.

Die Beschichtungsanlagen 1 gemäss den Ausführungsbeispielen in Fig. 4 und 5 sind nicht nur hinsichtlich der Zuftversorgung und der Abluftentsorgung weitgehend unabhängig von der Infrastruktur am Aufstellort. Sie weisen auch ein deutlich reduziertes Reinraumvolumen auf. Dadurch, dass die Beschichtungsstation 2 von der Umgebungsluft praktisch abgeschottet ist, und das Reinraumvolumen auf den Raum beschränkt ist, der sich innerhalb der Abschottung 19, 17 ausdehnt, kann sogar darauf verzichtet werden, in dem Raum oder der Halle, in der die Beschichtungsstation aufgestellt ist, Reinraumqualität bereitzustellen. Die vor der ersten Inbetriebnahme der Beschichtungsanlage 1 innerhalb der Abschottung 19, 17 befindliche Luft wird beim Betrieb der Anlage gegen Luft ausgetauscht, die von dem Luftaufbereitungsmodul 20 bereitgestellt wird. Dazu kann an der Unterseite des Gehäuses 21 des Luftaufbereitungsmoduls 20 eine separate Zulufteinspeisung vorgesehen sein. Im allgemeinen reicht aber die Luft aus, die vom Ausgang der Vorwärmstation 15 bzw. vom Eingang der Ablüft- und Trockenstation 6 in die Beschichtungsstation 2 gelangt.

Eine derartige Beschichtungsanlage erfordert keine Installationen für die Zuluft oder die Abluft, aufwendige Reinraumvorkehrungen können entfallen. Es ist nur noch erforderlich, die einzelnen Aggregate der Beschichtungsanlage mit Energie zu versorgen. Dies erfordert nur mehr die Verbindung eines einzigen Hauptversorgungsanschlusses mit dem am Standort vorhandenen Energienetz. Die einzelnen Aggregate werden von einer in der Beschichtungsanlage integrierten Verteilerstation mit Energie versorgt (nicht dargestellt).

Die erfindungsgemässe Beschichtungsanlage ist weitgehend autonom von der Infrastruktur am Austellungsort. Die gesamte Luftaufbereitung ist in die Beschichtungsanlage integriert. Dabei wird bereits vorhandener und sonst ungenützter Platz ausgenützt. Das erforderlich Reinraumvolumen ist reduziert, auf kostenintensive Anlagen für die Bereitstellung der erforderlichen Reinraumqualität kann weitgehend verzichtet werden. Die Beschichtungsanlage bleibt trotz der Integration der gesamten Luftaufbereitung kompakt; durch den Wegfall von Installationen und Rohrleitungen für die Luftführung ist der Platzbedarf sogar reduziert. Die erforderliche Zeit für die Aufstellung und die Aufstellungskosten sind reduziert

## Patentansprüche

1. Vorrichtung zum Beschichten von plattenförmigem Gut, insbesondere von Leiterplatten, umfassend eine Beschichtungsstation (2) mit einem Giesstisch (3), zur Beschichtung einer Oberfläche des Guts mit vorzugsweise UV-härtbarem Kunststoff oder Lack und daran angeschlossen eine Ablüft- und Trockenstation (6) mit einem Ablüfttrockner (7) zum Ablüften und Trocknen der beschichteten Oberflächen des Guts im Heissluftstrom, dadurch gekennzeichnet, dass die Ablüft- und Trockenstation (6) ein Luftaufbereitungsmodul (20) aufweist, welches in einem Gehäuse (21) angeordnet ist, das eingabeseitig an das Gehäuse (21) des Ablüfttrockners (7) anschliesst und sich über den freien Raum oberhalb des Giesstisches (3) erstreckt.

2. Vorrichtung nach Anspruch 1, dadurch gekennzeichnet, dass das Gehäuse (21) des Luftaufbereitungsmoduls (20) fest mit dem Gehäuse (8) des Ablüfttrockners (7) verbunden ist, dass die Abmessungen des Gehäuses (21) des Luftaufbereitungsmoduls (20) derart gewählt sind, dass es nicht über die Höhe und die Breite des Ablüftrockners (7) hinausragt, und dass seine Länge (Y) der Länge (X) der Beschichtungsstation (6) entspricht.

3. Vorrichtung nach Anspruch 1 oder 2, dadurch gekennzeichnet, dass das Luftaufbereitungsmodul (20) erste Umwälzeinrichtungen (28) für die Zuluft und zweite Umwälzeinrichtungen (29) für die Abluft aufweist, die in entsprechenden Zuluft- bzw. Abluftleitungen (25 bzw. 27) angeordnet sind, welche einerseits mit entsprechenden Zuluftöffnungen (23) bzw. Abluftanschlüssen (26) im Gehäuse (21) des Luftaufbereitungsmoduls (20) verbunden sind und andererseits mit einem Zuluft- bzw. Abluftkanal (11 bzw. 12) des Ablüfttrockners (7) verbunden sind, welche Kanäle (11, 12) eingangseitig (9) des als Umlauftrockner ausgebildeten Ablüfttrockners (7) münden, und dass zwischen der ersten Umwälzeinrichtung (28) und der Mündung der Zuluftleitung (25) in den Zuluftkanal (11) eine Heizeinrichtung (30) für die Zuluft innerhalb des Gehäuses (21) angeordnet ist, die mit einer Thermostateinrichtung (14) verbunden ist, die eingangsseiting im Inneren des Ablüfttrockners (7) angeordnet ist, und mit Hilfe welcher die Erwärmung der Zuluft nach Massgabe der gewünschten Temperatur im Ablüfttrockner (7) regelbar ist

4. Vorrichtung nach Anspruch 3, dadurch gekennzeichnet, dass die erste und zweite Umwälzeinrichtung (28, 29) Ventilatoren sind, deren Förderleistung regelbar ist und dass die Heizeinrichtung (30) für die Zuluft eine automatisch regelbare elektrische Widerstandsheizung ist.

5. Vorrichtung nach Anspruch 4, dadurch gekennzeichnet, dass zwischen der ersten Umwälzeinrichtung (28) und der elektrischen Widerstandsheizung (30) ein Wärmetauscher (31) angeordnet ist, der einerseits mit der Zuluftleitung (25) und andererseits mit der Abluftleitung (27) verbunden ist, und der zur Vorwärmung der Zuluft ausgebildet ist

6. Vorrichtung nach einem der Ansprüche 3 bis 5, dadurch gekennzeichnet, dass zwischen der ersten Umwälzeinrichtung (28) und dem Wärmetauscher (31) eine Abzweigleitung (33) vorgesehen ist, die mit einem Kaltluftkanal (13) des Ablüfttrockners (7) verbunden ist, der ausgangsseitig (10) des Ablüfttrockners (7) in dessen Innerem mündet und zur Kühlung der getrockneten Leiterplatten dient.

7. Vorrichtung nach einem der Ansprüche 3 bis 6, dadurch gekennzeichnet, dass die Zuluftöffnung (23) mit einem Zuluftfilter (24) ausgestattet ist.

8. Vorrichtung nach einem der Ansprüche 3 bis 7, dadurch gekennzeichnet, dass zwischen der zweiten Umwälzeinrichtung (29) für die Abluft und dem Abluftanschluss (26) in der Abluftleitung (27) eine Abluftreinigungseinrichtung (32) angeordnet ist, die vorzugsweise als katalytische Abluftverbrennungsanlage ausgebildet ist.

9. Vorrichtung nach einem der Ansprüche 5 bis 8, dadurch gekennzeichnet, dass das Luftaufbereitungsmodul (20) je einen Zuluft- und Abluftversorgungsanschluss (34 bzw. 36) für eine Vortrockenstation (15) aufweist, welche Anschlüsse (34, 36) auf der dem Ablüfttrockner (7) abgewandten Stirnseite (22) des Gehäuses (21) des Luftaufbereitungsmoduls (20) angeordnet sind, wobei der Zuluftversorgungsanschluss (34) aus einer Zuluftversorgungsleitung (35) mündet, die nach der Heizeinrichtung (30) von der Zuluftleitung (25) abzweigt und erhitzte Luft führt, und wobei der Abluftversorgungsanschluss (36) mit einer Abluftentsorgungsleitung (37) verbunden ist, die vor dem Wärmetauscher (31) in die Abluftleitung (27) mündet.

10. Vorrichtung nach Anspruch 9, dadurch gekennzeichnet, dass in der Zuluftversorgungsleitung (34) für die Vortrockenstation (15) ein automatisch steuerbarer Luftmischer (38) angeordnet ist, in den eine Kaltluftleitung (39) mündet, die zwischen der ersten Umwälzeinrichtung (28) und dem Wärmetauscher (31) von der Zuluftleitung (25) abzweigt, welcher Luftmischer (38) mit einer Thermostateinrichtung (18) verbunden ist, die innerhalb der Vorwärmstation (15) angeordnet ist und mit Hilfe welcher das Verhältnis von erhitzter und von kalter Zuluft im Luftmischer (38) nach Massgabe der gewünschten Temperatur in der Vorwärmstation (15) regelbar ist.

11. Vorrichtung nach einem der Ansprüche 1 bis 10, dadurch gekennzeichnet, dass die Beschichtungsstation (2) durch bauliche Massnahmen im wesentlichen von der Umgebungluft abgeschottet ist.

12. Vorrichtung nach Anspruch 11, dadurch gekennzeichnet, dass die Abschottung der Beschichtungsstation (2) durch zwei Plexiglaswände (19) gebildet ist, die zu beiden Längsseiten der Beschichtungsstation (2) von der Unterkante des Gehäuses (21) für das Luftaufbereitungsmodul (20) bis zum Boden reichen und sich von der eingangsseitigen Gehäusewand des Ablüfttrockners (7) über die gesamte Länge (X) der Beschichtungsstation (2) erstrecken und an eine eingangsseitig (4) der Beschichtungsstation (2) angeordnete Stirnschottwand (17) anschliessen.

13. Vorrichtung nach Anspruch 12, dadurch gekennzeichnet, dass die Stirnschottwand (17) durch die ausgangsseitige Wand des Gehäuses (16) einer Vorwärmstation (15) gebildet ist.

14. Vorrichtung nach einem der vorangehenden Ansprüche, dadurch gekennzeichnet, dass im Anschluss an die erste Ablüft- und Trockenstation (6) eine zweite Beschichtungsstation (2A) zur Beschichtung der zweiten Oberfläche der Leiterplatten und daran anschliessend eine zweite Ablüft- und Trockenstation (6A) angeordnet ist, die wenigstens einen Ablüfttrockner (7A) mit integriertem Luftaufbereitungsmodul (20A) umfasst.

15. Vorrichtung nach Anspruch 14, dadurch gekennzeichnet, dass die Beschichtungsstationen im wesentlichen gegenüber der Umgebungsluft abgeschottet sind.

## Claims

1. An apparatus for coating board-shaped articles, especially printed circuit boards, comprising a coating station (2) having a pouring table (3) for coating one surface of the articles with preferably UV-hardenable plastics or lacquer, and, adjoining that station, a vapour-removal and drying station (6) having a vapour-removal drier (7) for the removal of vapour from and drying of the coated surfaces of the articles in the stream of hot air, wherein the vapour-removal and drying station (6) has an air processing module (20) which is arranged in a housing (21) which adjoins the entrance side of the housing (21) of the vapour-removal drier (7) and extends over the free space above the pouring table (3).

2. An apparatus according to claim 1, wherein the housing (21) of the air processing module (20) is fixedly connected to the housing (8) of the vapour-removal drier (7), the dimensions of the housing (21) of the air processing module (20) are so selected that it does not project beyond the height and the width of the vapour-removal drier (7), and its length (Y) corresponds to the length (X) of the coating station (6).

3. An apparatus according to claim 1 or claim 2, wherein the air processing module (20) comprises first circulating devices (28) for the inlet air and second circulating devices (29) for the exhaust air which are arranged in corresponding air-inlet and exhaust-air lines (25 and 27, respectively) which are connected on the one hand to corresponding air-inlet openings (23) and exhaust-air connections (26), respectively, in the housing (21) of the air processing module (20) and, on the other hand, to an air-inlet and exhaust-air duct (11 and 12, respectively) of the vapour-removal drier (7), which ducts (11, 12) open into the entrance side (9) of the vapour-removal drier (7) which is constructed as a circulating drier, and there is arranged between the first circulating device (28) and the site where the air-inlet line (25) opens into the air-inlet duct (11) a heating device (30) for the inlet air inside the housing (21), which heating device (30) is connected to a thermostat device (14) which is arranged inside the vapour-removal drier (7), on the entrance side thereof, and by means of which the heating of the inlet air can be regulated in accordance with the desired temperature in the vapour-removal drier (7).

4. An apparatus according to claim 3, wherein the first and second circulating devices (28, 29) are fans, the output of which can be regulated, and the heating device (30) for the inlet air is an electrical resistance heater that can be regulated automatically.

5. An apparatus according to claim 4, wherein there is arranged between the first circulating device (28) and the electrical resistance heater (30) a heat exchanger (31) which is connected on the one hand to the air-inlet line (25) and on the other hand to the exhaust-air line (27) and is constructed to preheat the inlet air.

6. An apparatus according to any one of claims 3 to 5, wherein there is provided between the first circulating device (28) and the heat exchanger (31) a branch line (33) which is connected to a cold-air duct (13) of the vapour-removal drier (7), which duct opens into the interior of the vapour-removal drier (7) at its exit side (10) and is used to cool the dried printed circuit boards.

7. An apparatus according to any one of claims 3 to 6, wherein the air-inlet opening (23) is equipped with an inlet-air filter (24).

8. An apparatus according to any one of claims 3 to 7, wherein there is arranged between the second circulating device (29) for the exhaust air and the exhaust-air connection (26) in the exhaust-air line (27) an exhaust-air purifying device (32) which is constructed preferably as a catalytic exhaust-air combustion installation.

9. An apparatus according to any one of claims 5 to 8, wherein the air processing module (20) has an inlet-air and an exhaust-air service connection (34 and 36, respectively) for a predrying station (15), which connections (34, 36) are arranged at the end (22) of the housing (21) of the air processing module (20) that is remote from the vapour-removal drier (7), the inlet-air service connection (34) opening out from an inlet-air supply line (35) which branches off from the air-inlet line (25) downstream of the heating device (30) and conveys heated air, and the exhaust-air service connection (36) being connected to an exhaust-air removal line (37) which opens into the exhaust-air line (27) upstream of the heat exchanger (31).

10. An apparatus according to claim 9, wherein there is arranged in the inlet-air supply line (34) for the predrying station (15) an air mixer (38) which can be controlled automatically and into which opens a cold-air line (39) which branches off from the air-inlet line (25) between the first circulating device (28) and the heat exchanger (31), which air mixer (38) is connected to a thermostat device (18) which is arranged inside the preheating station (15) and by means of which the ratio of heated inlet air and cold inlet air in the air mixer (38) can be regulated in accordance with the desired temperature in the preheating station (15).

11. An apparatus according to any one of claims 1 to 10, wherein the coating station (2) is substantially sealed off from the surrounding air by structural measures.

12. An apparatus according to claim 11, wherein the sealing of the coating station (2) is effected by two Plexiglas walls (19) which run, on both longitudinal sides of the coating station (2), from the lower edge of the housing (21) for the air processing module (20) as far as the floor and extend from the wall on the entrance side of the housing of the vapour-removal drier (7) along the entire length (X) of the coating station (2) and adjoin an end sealing wall (17) arranged on the entrance side (4) of the coating station (2).

13. An apparatus according to claim 12, wherein the end sealing wall (17) is formed by the wall at the exit side of the housing (16) of a preheating station (15).

14. An apparatus according to any one of the preceding claims, wherein there is arranged following the first vapour-removal and drying station (6) a second coating station (2A) for coating the second surface of the printed circuit boards and, following that station, a second vapour-removal and drying station (6A) which comprises at least one vapour-removal drier (7A) having an integrated air processing module (20A).

15. An apparatus according to claim 14, wherein the coating stations are substantially sealed off from the surrounding air.

## Revendications

1. Dispositif pour le revêtement d'articles en forme de plaques, en particulier de plaques à circuit imprimé, comportant une station de revêtement (2) avec une table de coulée (3) pour revêtir de plastique, ou de laque, de préférence durcissable aux UV, une surface de l'article et, la jouxtant, une station d'élimination de l'air de séchage (6) avec un séchoir d'air à éliminer (7) pour sécher les surfaces de l'article revêtues, en éliminant l'air, dans un flux d'air chaud, caractérisé par le fait que la station d'élimination de l'air et de séchage (6) présente un module (20) de préparation de l'air qui est disposé dans une carrosserie (21) qui, du côté de l'entrée, se raccorde à la carrosserie (21) du séchoir d'air à éliminer (7) et s'étend sur l'espace libre existant au-dessus de la table de coulée (3).

2. Dispositif selon la revendication 1, caractérisé par le fait que la carrosserie (21) du module (20) de préparation de l'air est solidarisée avec la carrosserie (8) du séchoir de l'air à éliminer (7), que les dimensions de la carrosserie (21) du module (20) de préparation de l'air sont choisies de façon à ne déborder ni au-delà de la hauteur ni au-delà de la largeur du séchoir de l'air à éliminer (7) et de façon que sa longueur (Y) corresponde à la longueur (X) de la station de revêtement (6).

3. Dispositif selon la revendication 1 ou 2, caractérisé par le fait que le module (20) de préparation de l'air présente des premiers dispositifs de recyclage(28) pour l'air entrant et des seconds dispositifs de recyclage (29) pour l'air à éliminer, dispositifs qui sont disposés sur les conduites correspondantes de l'air entrant ou de l'air à éliminer (25 ou 27), qui sont d'une part reliées avec des ouvertures d'entrée d'air appropriées (23) ou à des raccords (26) pour l'air à éliminer prévus dans la carrosserie (21) du module (20) de préparation de l'air et sont d'autre part reliées à un canal d'air entrant ou à un canal d'air à éliminer (11 ou 12) du séchoir de l'air à éliminer (7), canaux (11, 12) qui débouchent du côté entrée (9) du séchoir de l'air à éliminer (7) conçu sous forme de séchoir tournant, et qu'entre le premier dispositif de recyclage (28) et l'embouchure de la conduite d'air entrant (25) est disposé à l'intérieur de la carrosserie (21) un dispositif de chauffage (30) pour l'air entrant qui est relié à un dispositif thermostatique (14) qui est disposé du côté entrée à l'intérieur du séchoir de l'air à éliminer (7) et à l'aide duquel le chauffage de l'air entrant est réglable en fonction de la température désirée dans le séchoir de l'air à éliminer (7).

4. Dispositif selon la revendication 3, caractérisé par le fait que le premier et le second dispositifs de recyclage (28, 29) sont (les ventilateurs dont le débit est réglable et que le dispositif de chauffage (30) pour l'air entrant est un chauffage par résistance électrique automatiquement réglable.

5. Dispositif selon la revendication 4, caractérisé par le fait qu'entre le premier dispositif de recyclage (28) et le chauffage par résistance électrique (30) est disposé un échangeur de chaleur (31) qui est relié d'une part avec la conduite d'air entrant (25) et d'autre part avec la conduite d'air à éliminer (27) et qui est conçu pour préchauffer l'air entrant.

6. Dispositif selon l'une des revendications 3 à 5, caractérisé par le fait qu'entre le premier dispositif de recyclage (28) et l'échangeur de chaleur (31) est prévue une conduite de dérivation (33) qui est reliée à un canal d'air froid (13) du séchoir de l'air à éliminer (7), qui, du côté de la sortie (10) du séchoir de l'air à éliminer (7), débouche dans l'intérieur de ce séchoir et sert à refroidir les plaques à circuit imprimé, séchées.

7. Dispositif selon l'une des revendications 3 à 6, caractérisé par le fait que l'ouverture d'entrée d'air (23) est équipée d'un filtre (24) sur l'air entrant.

8. Dispositif selon l'une des revendications 3 à 7, caractérisé par le fait qu'entre le second dispositif de recyclage (29). prévu pour l'air à éliminer, et le raccord (26) pour l'air à éliminer sur la conduite d'air à éliminer (27) est disposé un dispositif (32) d'épuration de l'air à éliminer qui est de préférence conçu sous forme d'installation de combustion catalytique de l'air à éliminer.

9. Dispositif selon l'une des revendications 5 à 8, caractérisé par le fait que le module (20) de préparation de l'air présente à la fois un raccord d'entrée de l'air entrant (34) et un raccord de sortie de l'air à éliminer (36) pour une station de préséchage (15), raccords (34, 36) qui sont disposés sur la face frontale (22), opposée au séchoir de l'air à éliminer (7), de la carrosseric (21) du module (20) de préparation de l'air, le raccord d'entrée de l'air entrant (34) provenant d'une conduite d'alimentation en air entrant (35) qui dérive de la conduite d'air entrant (25), après le dispositif de chauffage (30), et dans laquelle passe de l'air réchauffé, et le raccord de sortie de l'air à éliminer (36) étant relié à une conduite (37) d'évacuation de l'air à éliminer qui débouche dans la conduite d'air à éliminer (27), en avant de l'échangeur de chaleur (31).

10. Dispositif selon la revendication 9, caractérisé par le fait que sur la conduite (34) d'alimentation en air entrant pour la station de préséchage (15) est disposé un mélangeur d'air (38), à commande automatique, dans lequel débouche une conduite d'air froid (39) qui dérive de la conduite d'air entrant (25) entre le premier dispositif de recyclage (28) et l'échangeur de chaleur (31), mélangeur d'air (38) qui est relié à un dispositif thermostatique (18) qui est disposé à l'intérieur de la station de préchauffage (15) et à l'aide duquel la proportion d'air entrant chauffé et d'air entrant froid dans le mélangeur d'air (38) est réglable selon la température désirée dans la station de préchauffage (15).

11. Dispositif selon l'une des revendications 1 à 10, caractérisé par le fait que la station de revêtement (2) est essentiellement séparée, de façon étanche, de l'air environnant par des mesures constructives.

12. Dispositif selon la revendication 11, caractérisé par le fait que la séparation étanche de la station de revêtement (2) est formée par deux parois de Plexiglas (19) qui, sur les deux côtés longitudinaux de la station de revêtement (2). vont du bord inférieur de la carrosserie (21) du module (20) de préparation de l'air jusqu'au sol et, depuis la paroi, de la carrosserie du séchoir de l'air à éliminer (7), du côté entrée, s'étendent sur toute la longueur (X) de la station de revêtement (2) et se raccordent à une paroi étanche frontale (17) disposée du côté de l'entrée (4) de la station de revêtement (2).

13. Dispositif selon la revendication 2, caractérisé par le fait que la paroi étanche frontale (17) est formée par la paroi, située du côté de la sortie, de la carrosserie (16) d'une station de préchauffage (15).

14. Dispositif selon l'une des revendications précédentes, caractérisé par le fait que jouxtant la première station d'élimination de l'air et de séchage (6), est disposée une seconde station de revêtement (2A) pour le revêtement de la seconde face des plaques à circuit imprimé et que, la jouxtant, est disposée une seconde station d'élimination de l'air et de séchage (6A) qui comporte au moins un séchoir de l'air à éliminer (7A) avec module intégré (20A) de préparation de l'air.

15. Dispositif selon la revendication 14, caractérisé par le fait que les stations de revêtement sont essentiellement rendues étanches à l'égard de l'air ambiant.
